# EUROPEAN PATENT APPLICATION

(11) **EP 4 560 248 A1**
(43) Date of publication of application: **28.05.2025**
(21) Application number: 24211099.7
(22) Date of filing: 06.11.2024
(51) Int. Cl.: F28F 21/08, H05K 7/20

(54) **IMMERSION-TYPE HEAT DISSIPATING DEVICE**

(30) Priority: 24.11.2023 TW 112145546
(71) Applicant: Cooler Master Co., Ltd., Taipei City 114065 (TW)
(72) Inventor: PENG, Cheng-Shu, 114065 Taipei City (TW); KUO, Sy-Chi, 114065 Taipei City (TW); WANG, Tz-Hao, 114065 Taipei City (TW)
(74) Representative: Grünecker Patent- und Rechtsanwälte PartG mbB

(57) **Abstract**

Immersion-type heat dissipating device thermally coupled to heat source includes heat conductor and boiling enhancement layer. The heat conductor includes a plurality of fin portions and a base portion, which is thermally coupled to the heat source and has heat receiving surface and heat dissipating surface opposite to each other. The fin portions protrude from the heat dissipating surface of the base portion. The boiling enhancement layer, which is disposed on at least part of the heat dissipating surface and at least part of the fin portions, includes at least one first metal portion and at least one second metal portion. A specific surface area of the at least one first metal portion is larger than a specific surface area of the at least one second metal portion.

## Description

### TECHNICAL FIELD

The present disclosure relates to an immersion-type heat dissipating device (which may be referenced herein, for convenience and without limitation, as an "immersion boiler" or an "immersion radiator"), in particular an immersion-type heat dissipating device / immersion boiler / immersion radiator having a boiling enhancement layer.

### BACKGROUND OF THE DISCLOSURE

With the rapid development of science and technology, the computing performance of various kinds of electronic components has improved considerably, with large amounts of heat being produced at the same time. To ensure that an electronic component is not damaged due to high heat, a cooling device must be fitted to the electronic component to dissipate excess heat.

Generally, electronic components are often cooled by a two-phase immersion cooling system, to maintain their performance and service life. The meaning of "two-phase immersion cooling system" is that a boiler thermally coupled to an electronic component in the cooling system is immersed in a liquid working fluid, and the liquid working fluid is heated through contact with the boiler, thereby undergoing a phase change, and thus evaporating to become gaseous working fluid, so as to produce bubbles and carry away heat generated by the electronic component. However, in existing immersion cooling systems, the efficiency of bubble production by the working fluid is still inadequate. That is to say, the efficiency with which existing immersion cooling systems cool electronic components is unable to meet the requirements of users. Thus, the issue of how to increase the efficiency with which immersion cooling systems cool electronic components is a problem in need of solution by research and development personnel.

### SUMMARY OF THE DISCLOSURE

Exemplary embodiments of the present disclosure provide an immersion boiler which may, but is not required to, increase the efficiency with which an immersion cooling system cools an electronic component.

The invention is as defined in the appended claims. An immersion boiler according to exemplary implementations of exemplary embodiments of the present disclosure can be configured to be thermally coupled to at least one heat source. The immersion boiler comprises a heat conductor and a boiling enhancement layer. The heat conductor comprises a base portion and can comprise multiple fin portions. The base portion comprises a heat receiving surface and a heat dissipating surface which are opposite each other. The heat receiving surface is configured to be thermally coupled to the at least one heat source. The fin portions can protrude from the heat dissipating surface of the base portion. The boiling enhancement layer is arranged on at least part of the heat dissipating surface of the base portion and can be arranged at least part of the fin portions. The boiling enhancement layer comprises at least one first metal portion and at least one second metal portion. A specific surface area of the at least one first metal portion is greater than a specific surface area of the at least one second metal portion.

According to the present disclosure, an immersion boiler can comprise a boiling enhancement layer, so that for example when the immersion boiler is immersed in a working fluid and thermally coupled to the heat source, the area of contact between the working fluid and the fin portions of the heat conductor can be increased, and a position for bubble production can be provided, by means of the boiling enhancement layer, for example such that the working fluid undergoes a phase change to carry away heat more efficiently, for example so that liquid working fluid evaporates by being heated to become gaseous working fluid, thus producing bubbles and carrying away heat more efficiently, thereby potentially increasing the cooling efficiency.

According to the present disclosure, within the boiling enhancement layer, the specific surface area of the first metal portion corresponding to a main heat zone can be greater than the specific surface area of the second metal portion corresponding to a secondary heat zone, for example so as to further increase the area of contact between the working fluid and the fin portions located at the main heat zone, which can for example, increase the density of bubble production per unit area of the main heat zone; thus, potentially further increasing the cooling efficiency.

The description of the content of the present disclosure above and the description of exemplary embodiments below are intended to demonstrate and explain the principle of the present disclosure, and can facilitate further understanding of the appended claims of the present disclosure.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
Fig. 1 is a 3D schematic drawing of an immersion boiler according to a first exemplary embodiment of the present disclosure.
Fig. 2 is a sectional schematic drawing of the immersion boiler in Fig. 1.
Fig. 3 shows a microscopic structure of the boiling enhancement layer in Fig. 1.
Fig. 4 shows another microscopic structure of the boiling enhancement layer in Fig. 1.
Fig. 5 shows another microscopic structure of the boiling enhancement layer in Fig. 1.
Fig. 6 is a sectional schematic drawing of an immersion boiler according to a second exemplary embodiment of the present disclosure.
Fig. 7 is a 3D schematic drawing of an immersion boiler according to a third exemplary embodiment of the present disclosure.

### DETAILED DESCRIPTION OF EXEMPLARY EMBODIMENTS

The matters exemplified in this description are provided to assist in a comprehensive understanding of exemplary embodiments of the disclosure. Accordingly, those of ordinary skill in the art will recognize that various changes and modifications of the embodiments described herein can be made without departing from the scope and spirit of the described disclosure. Also, descriptions of well-known functions and constructions are omitted for clarity and conciseness.

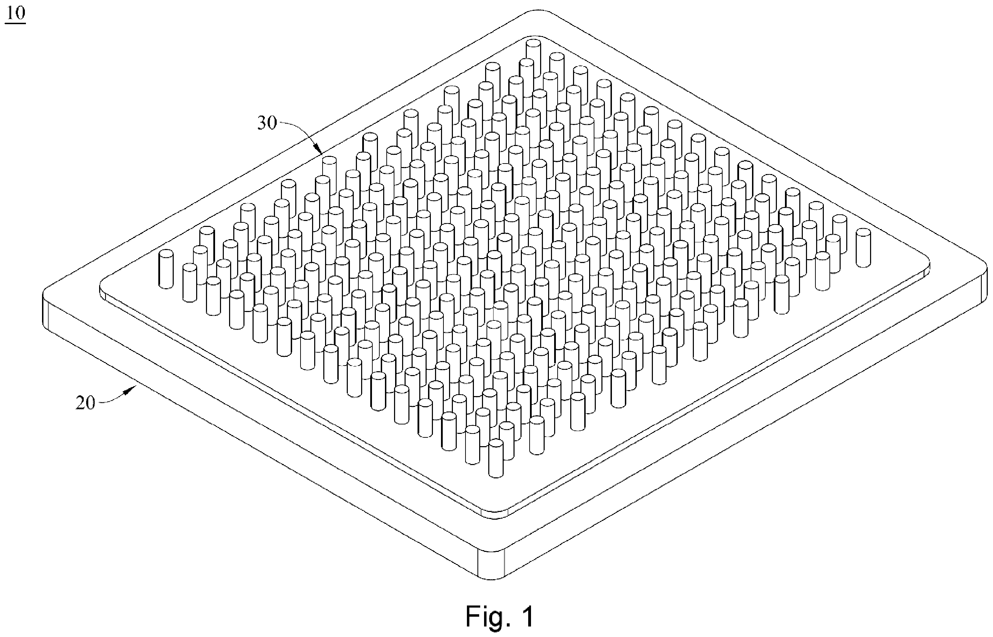

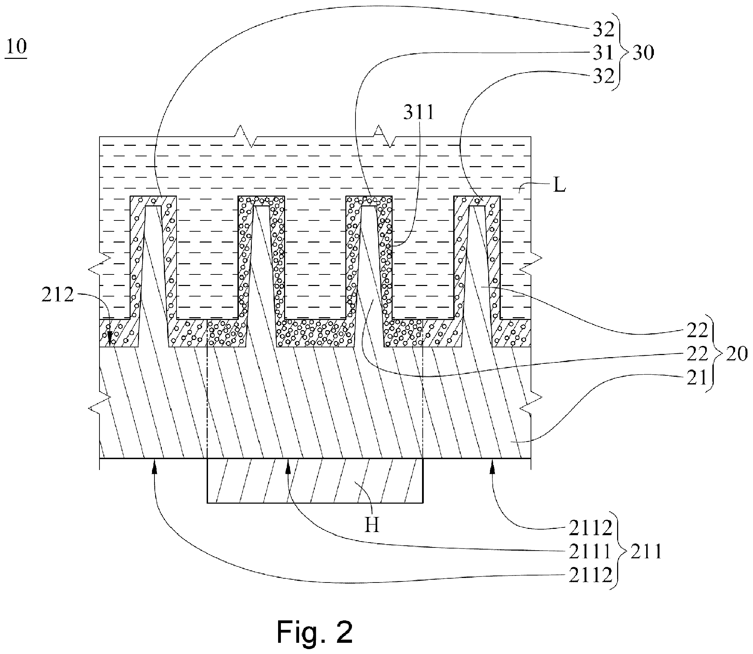

Please refer to Figs 1 and 2. Fig. 1 is a 3D schematic drawing of an immersion boiler according to a first exemplary embodiment of the present disclosure. Fig. 2 is a sectional schematic drawing of the immersion boiler in Fig. 1.

According to exemplary implementations of exemplary embodiments, such as a first exemplary embodiment, an immersion boiler 10 can be configured to be thermally coupled to a heat source H and, for example, immersed in a working fluid L. The working fluid L can be, for example and without limitation, an electrically non-conductive fluorinated liquid or another electronic engineering liquid. In an exemplary implementation, the immersion boiler 10 can comprise a heat conductor 20 and a boiling enhancement layer 30. For example, the heat conductor 20 can comprise a base portion 21 and multiple fin portions 22. The base portion 21 is for example a metal plate, a vapor chamber, a heat pipe or a combination thereof, and has a heat receiving surface 211 and a heat dissipating surface 212 which are opposite each other. The heat receiving surface 211 can be differentiated into a main heat zone 2111 and multiple secondary heat zones 2112. The main heat zone 2111 and the secondary heat zones 2112 can be arranged in an alternating manner, and the main heat zone 2111 can be configured to be thermally coupled to the heat source H. In exemplary implementations of disclosed exemplary embodiments, the meaning of the term "thermally coupled" includes, for example, being in thermal contact, or being connected via another heat-conducting medium.

According to further exemplary implementations of exemplary embodiments, such as the first exemplary embodiment, the fin portions 22 can be joined to the base portion 21 by, for example, integral forming, sintering, welding or a combination thereof, and the fin portions 22 protrude from the heat dissipating surface 212 of the base portion 21. For example, the heat conductor 20 can be a vapor chamber, a 3D vapor chamber, or a combination of a vapor chamber and fins. For example, the fin portions 22 can be configured to progressively decrease in width from the bottom toward the top.

According to yet further exemplary implementations of exemplary embodiments, the boiling enhancement layer 30 can be for example a powder sintered structure, a polygonal deposit structure, an etched microstructure or a combination thereof, and can be arranged on part of the heat dissipating surface 212 and all of the fin portions 22. For example, the boiling enhancement layer 30 can be configured to allow the working fluid L to receive heat conducted by the heat dissipating surface 212 and the fin portions 22 and thereby undergo a phase change, for example so that liquid working fluid evaporates by being heated to become gaseous working fluid, thus for example producing bubbles and carrying away heat. For example, the boiling enhancement layer 30 can comprise a first metal portion 31 and multiple second metal portions 32. The material of the first metal portion 31 and the second metal portions 32 can be selected for example from the group consisting of pure copper, copper alloy, pure nickel, nickel alloy and combinations thereof, and the first metal portion 31 and the second metal portions 32 can be manufactured by, for example, sintering, etching, vapor deposition, electrochemical deposition or a combination thereof.

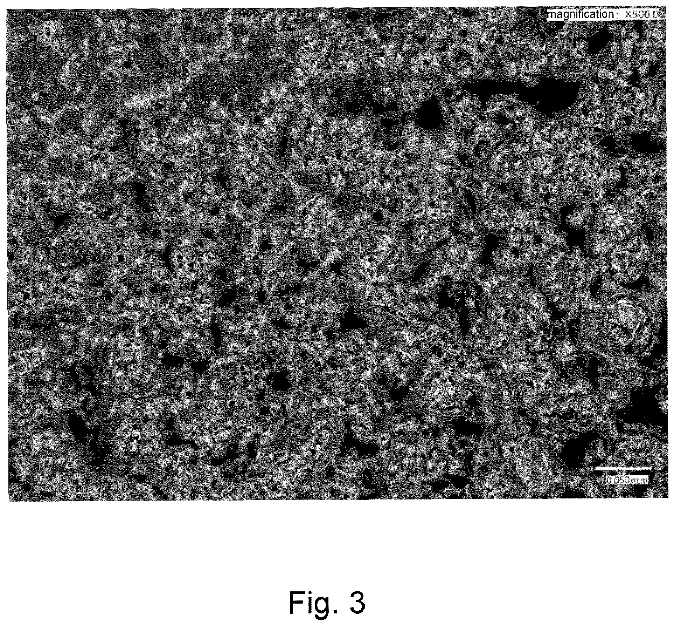

Referring to Fig. 3, which shows a microscopic structure of the boiling enhancement layer in Fig. 1, where according to exemplary embodiments, the first metal portion 31 and the second metal portions 32 of the boiling enhancement layer 30 can, for example, be formed by powder sintering. According to an exemplary implementation, powder accumulation can naturally form multiple pores. According to further exemplary implementation, sintering can close up some of these pores in the powder to form a continuous structure, for example thereby increasing the surface area of the first metal portion 31 and the second metal portions 32 in contact with the working fluid L, so as to increase the cooling efficiency. In addition, according to exemplary implementations, pores on the surface of the first metal portion 31 and the second metal portions 32 can help to provide positions for bubble nucleation, for example so as to further increase the cooling efficiency.

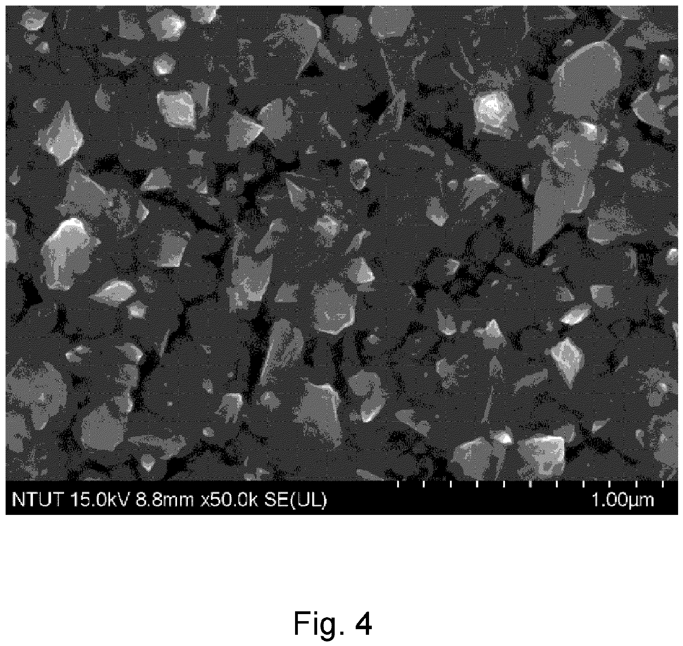

Referring to Fig. 4, which shows another microscopic structure of the boiling enhancement layer in Fig. 1, where according to exemplary embodiments, the first metal portion 31 and the second metal portions 32 of the boiling enhancement layer 30 may also for example be formed by electrochemical deposition. According to an exemplary implementation, a solution can be adjusted and deposition conditions can be controlled to form polygonal deposits on the surface of the metal. In this way, according to further exemplary implementation, a protruding structure of the polygonal deposits can increase the surface area of the first metal portion 31 and the second metal portions 32 in contact with the working fluid L, for example so as to increase the cooling efficiency. In addition, according to still further exemplary implementation, gaps between the polygonal deposits in the first metal portion 31 and the second metal portions 32 can help to provide positions for bubble nucleation, for example so as to further increase the cooling efficiency.

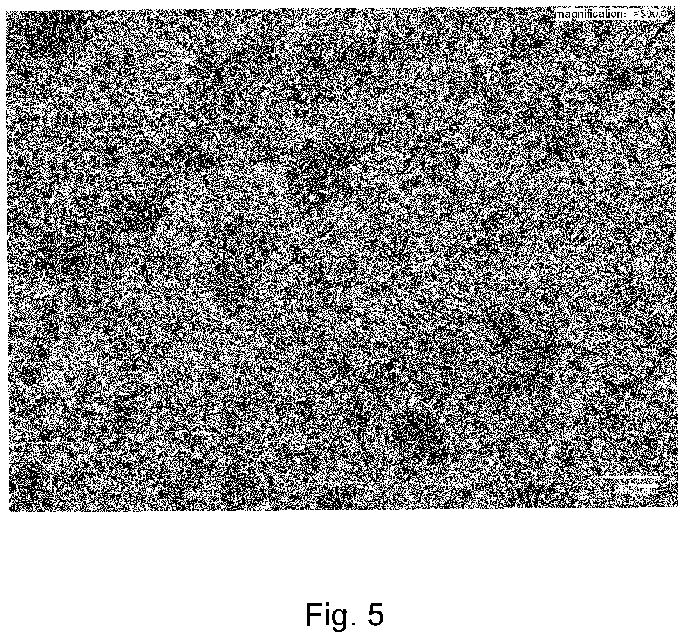

Referring to Fig. 5, which shows another microscopic structure of the boiling enhancement layer in Fig. 1, where according to exemplary embodiments, the first metal portion 31 and the second metal portions 32 of the boiling enhancement layer 30 may also for example be formed by etching. According to an exemplary implementation, wrinkles and etching holes may be formed on the surface of the metal by etching, to for example increase the surface area of the first metal portion 31 and the second metal portions 32 in contact with the working fluid L, for example so as to increase the cooling efficiency. In addition, according to still further exemplary implementation, the etching holes of the first metal portion 31 and the second metal portions 32 can help to provide positions for bubble nucleation, for example so as to further increase the cooling efficiency.

Referring to Figs 1 and 2, according to exemplary embodiments the first metal portion 31 and the second metal portions 32 can correspond to the main heat zone 2111 and the secondary heat zones 2112 respectively. According to an exemplary implementation, the specific surface area of the first metal portion 31 can be greater than the specific surface area of each second metal portion 32. According to a further exemplary implementation, specific surface area can be the total surface area of solid per unit mass. For example and without limitation, the number of holes in the first metal portion 31 may be greater than the number of holes in each second metal portion 32 so that, for example and without limitation, the specific surface area of the first metal portion 31 can be greater than the specific surface area of each second metal portion 32. In other exemplary embodiments, other methods may be used to ensure that the specific surface area of the first metal portion can be greater than the specific surface area of each second metal portion. In exemplary implementations, the first metal portion 31 can comprise multiple side portions 311 extending from the bottom of the fin portions 22 to the top of the fin portions 22. In further exemplary implementations, the side portions 311 can progressively increase in thickness from the bottom toward the top.

It should be noted that according to exemplary embodiments of the present disclosure, specific surface area is not equivalent to porosity. For example, porosity is the ratio of the volume of pores in a material to the total volume of the material. According to exemplary implementations, the importance of porosity to bubble production is lower than the importance of specific surface area to bubble production.

In accordance with embodiments of the present disclosure, an advantage of the immersion boiler 10 being provided with the boiling enhancement layer 30 can be, for example and without limitation, that when the immersion boiler 10 is immersed in the working fluid L and thermally coupled to the heat source H, the area of contact between the working fluid L and the fin portions 22 of the heat conductor 20 can be increased by means of the boiling enhancement layer 30, for example such that the working fluid undergoes a phase change more efficiently, so that liquid working fluid can evaporate by being heated to become gaseous working fluid, thus producing bubbles and carrying away heat more efficiently, thereby increasing the cooling efficiency.

Further, in accordance with embodiments of the present disclosure, within the boiling enhancement layer 30, the specific surface area of the first metal portion 31 corresponding to the main heat zone 2111 can be greater than the specific surface area of the second metal portion 32 corresponding to the secondary heat zone 2112, for example so as to further increase the area of contact between the working fluid L and the fin portions 22 located at the main heat zone 2111, and thus, for example and without limitation, increase the density of bubble production per unit area of the main heat zone 2111; thus, for example and without limitation, the cooling efficiency can be further increased.

Still further, in accordance with embodiments of the present disclosure, the boiling enhancement layer 30 can be arranged, for example and without limitation, on part of the heat dissipating surface 212 and all of the fin portions 22. According to exemplary implementations of disclosed embodiments, the boiling enhancement layer could be arranged on all of the heat dissipating surface and part of the fin portions.

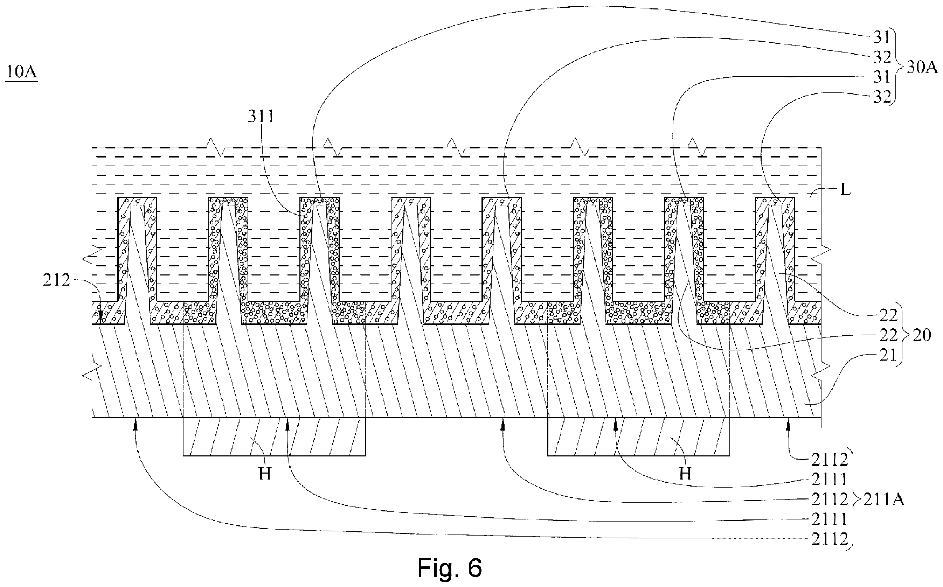

According to exemplary embodiments, the main heat zone 2111 can, for example and without limitation, be a single main heat zone, and the first metal portion 31 can, for example and without limitation, be a single first metal portion. Referring to Fig. 6, which is a sectional schematic drawing of an immersion boiler according to a second embodiment of the present disclosure, the immersion boiler 10A in a second exemplary embodiment can be similar to the immersion boiler 10 in a first exemplary embodiment. Exemplary implementations of exemplary embodiments, such as the second exemplary embodiment, are described below where feature that a similar to previously described embodiments, such as the first embodiment, are not described in detail for conciseness and the differences are noted by way of further examples and without limitation.

According to exemplary embodiments, such as the second embodiment, a heat receiving surface 211A of a base plate of the immersion boiler 10A may be differentiated into multiple main heat zones 2111 and multiple secondary heat zones 2112. In an exemplary implementation, the main heat zones 2111 and the secondary heat zones 2112 can be arranged in an alternating manner, and the main heat zones 2111 can be configured to be thermally coupled to multiple heat sources H. For example, and without limitation, the sizes of the heat sources H can be the same. In other exemplary embodiments, the sizes of the heat sources could be different. According to further exemplary implementations, the boiling enhancement layer 30A may also comprise multiple first metal portions 31 of larger specific surface area and multiple second metal portions 32 of smaller specific surface area, for example the first metal portions 31 and the second metal portions 32 respectively corresponding to the main heat zones 2111 and the secondary heat zones 2112.

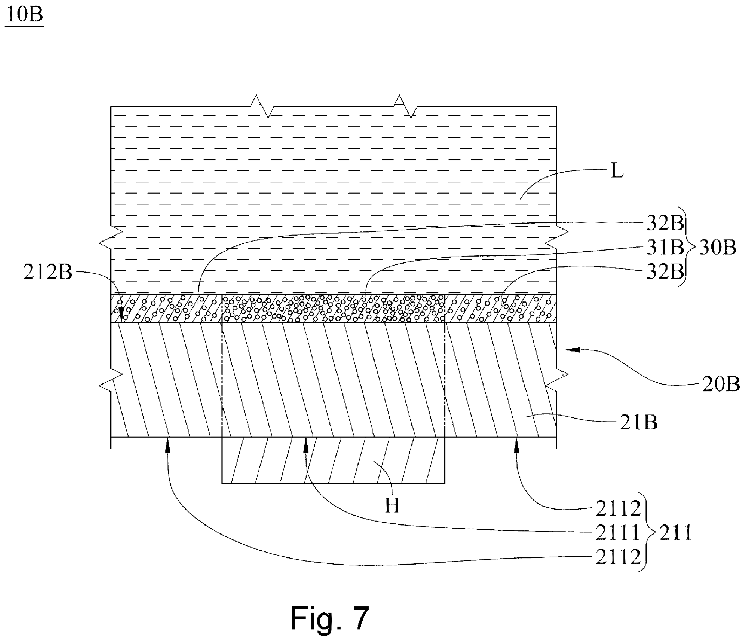

According to exemplary embodiments, such as the first exemplary embodiment, the heat conductor 20 of the immersion boiler 10 can comprise, for example and without limitation, fin portions 22. Referring to Fig. 7, which is a 3D schematic drawing of an immersion boiler according to a third exemplary embodiment of the present disclosure, the immersion boiler 10B in a third exemplary embodiment can similar to the immersion boiler 10 in the first exemplary embodiment. Exemplary implementations of exemplary embodiments, such as the third exemplary embodiment, are described below where feature that a similar to previously described embodiments, such as the first embodiment, are not described in detail for conciseness and the differences are noted by way of further examples and without limitation..

According to exemplary embodiments, such as the third exemplary embodiment, in the immersion boiler 10B a heat conductor 20B does not comprise fin portions. According to an exemplary implementation, a porous metal layer 30B can be arranged on part of a heat dissipating surface 212B of a base portion 21B in the heat conductor 20B. For example and without limitations, the porous metal layer 30B can comprises a first metal portion 31B and multiple second metal portions 32B. According to exemplary implementations, the first metal portion 31B and the second metal portions 32B respectively can correspond to the main heat zone 2111 and the secondary heat zones 2112, and the specific surface area of the first metal portion 31B can be greater than the specific surface area of each second metal portion 32B.

According to exemplary embodiments, such as the third exemplary embodiment, the boiling enhancement layer 30B can be arranged, for example and without limitations, on part of the heat dissipating surface 212B, but there is no limitation to this. In other exemplary embodiments, the boiling enhancement layer could be arranged on all of the heat dissipating surface.

In exemplary embodiments of the present disclosure, the immersion boiler as described above is can be provided with a boiling enhancement layer, so when the immersion boiler is immersed in the working fluid and thermally coupled to the heat source, the area of contact between the working fluid and the fin portions of the heat conductor can be increased by means of the boiling enhancement layer, such that, for example, the working fluid undergoes a phase change to carry away heat more efficiently, so that, for example and without limitation, liquid working fluid can evaporate by being heated to become gaseous working fluid, thus, for example and without limitation, producing bubbles and carrying away heat more efficiently, thereby increasing the cooling efficiency.

In addition, according to exemplary implementations of exemplary embodiments of the present disclosure, within the boiling enhancement layer, the specific surface area of the first metal portion corresponding to a main heat zone can be greater than the specific surface area of the second metal portion corresponding to a secondary heat zone, so as to, for example and without limitation, further increase the area of contact between the working fluid and the fin portions located at the main heat zone, and thus, for example and without limitation, increase the density of bubble production per unit area of the main heat zone; thus, for example and without limitation, the cooling efficiency can be further increased.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although exemplary embodiments have been disclosed through multiple exemplary implementations, these are not intended to limit the present disclosure, and those skilled in the art should be able to make changes and modifications without departing from the spirit of the present disclosure within the scope of appended claims, along with their full scope of equivalents.

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
10, 10A, 10B: immersion boiler
20, 20B: heat conductor
21, 21B: base portion
211, 211A: heat receiving surface
2111: main heat zone
2112: secondary heat zone
212, 212B: heat dissipating surface
22: fin portion
30, 30A, 30B: boiling enhancement layer
31, 31B: first metal portion
311: side portion
32, 32B: second metal portion
H: heat source

## Claims

1. A device comprising:
a heat conductor (20, 20B) comprising a base portion (21, 21B), the base portion (21, 21B) having a heat receiving surface (211. 211A) and a heat dissipating surface (212, 212B) opposite the heat receiving surface (211, 211A), the heat receiving surface (211, 211A) configured to be thermally coupled to at least one heat source (H); and
a boiling enhancement layer (30, 30A, 30B), arranged on at least part of the heat dissipating surface (212, 212B) of the base portion (21, 21B),
wherein the boiling enhancement layer (30, 30A, 30B) comprises at least one first metal portion (31, 31B) and at least one second metal portion (32, 32B), a first surface area of the at least one first metal portion (31, 31B) being greater than a second surface area of the at least one second metal portion (32, 32B).

2. The device as claimed in claim 1, wherein
the heat conductor (20) further comprises a plurality of fin portions (22), the fin portions (22) protruding from the heat dissipating surface (212) of the base portion (21); and
the boiling enhancement layer (30, 30A) is arranged on at least part of the heat dissipating surface (212) of the base portion (21) and at least part of the fin portions (22).

3. The device as claimed in claim 1 or 2, wherein
the heat receiving surface (211, 211A) of the base portion (21, 21B) is differentiated into at least one main heat zone (2111) and at least one secondary heat zone (2112),
the at least one main heat zone (2111) of the at least one heat receiving surface (211) being configured to be thermally coupled to the heat source (H), and
the at least one first metal portion (31, 31B) and the at least one second metal portion (32, 32B) corresponds to the at least one main heat zone (2111) and the at least one secondary heat zone (2112), respectively.

4. The device as claimed in claim 3, wherein
the at least one main heat zone (2111) comprises a plurality of first heat zones,
the at least one secondary heat (2112) zone comprises a plurality of second heat zones,
the at least one first metal portion (31) comprises a plurality of first metal portions,
the at least one second metal portion (32) comprises a plurality of second metal portions,
the first heat zones and the second heat zones are arranged in an alternating manner, and
the first metal portions (31) and the second metal portions (32) correspond to the first heat zones and the second heat zones, respectively.

5. The device as claimed in any one of claims 1 to 4, wherein the base portion (21, 21B) of the heat conductor (20, 20B) comprises a metal plate, a vapor chamber, a heat pipe, or a combination thereof.

6. The device as claimed in any one of claims 2 to 5, wherein the base portion (21) of the heat conductor (20) is joined to the fin portions (22) by integral forming, sintering, welding, or a combination thereof.

7. The device as claimed in any one of claims 1 to 6, wherein the boiling enhancement layer (30, 30A, 30B) comprises a powder sintered structure, a polygonal deposit structure, an etched microstructure, or a combination thereof.

8. The device as claimed in any one of claims 1 to 7, wherein the at least one first metal portion (31, 31B) and the at least one second metal portion (32, 32B) are manufactured by sintering, etching, vapor deposition, electrochemical deposition, or a combination thereof.

9. The device as claimed in any one of claims 1 to 8, wherein the material of the at least one first metal portion (31, 31B) and the at least one second metal portion (32, 32B) is selected from the group consisting of pure copper, copper alloy, pure nickel, nickel alloy, and combinations thereof.

10. The device as claimed in any one of claims 2 to 9, wherein the at least one first metal portion (31) comprises at least one side portion (311) extending from a bottom of the fin portions (22) to a top of the fin portions (22), the at least one side portion (311) progressively increasing in thickness from the bottom toward the top.

11. The device as claimed in any one of claims 2 to 10, wherein the fin portions (22) progressively decrease in width from a bottom of the fin portions toward a top of the fin portions.

12. The device as claimed in any one of claims 2 to 11, wherein the boiling enhancement layer (30, 30A, 30B) is arranged on all of the heat dissipating surface (212, 212B) of the base portion (21, 21B) and all of the fin portions (22).

13. The device as claimed in any one of claims 1 to12, wherein the device is an immersion-type heat dissipating device.

14. The device as claimed in any one of claims 1 to 12, wherein the device is an immersion boiler (10, 10A, 10B).

15. The device as claimed in any one of claims 1 to 12, wherein the device is an immersion radiator.
